# EUROPÄISCHE PATENTSCHRIFT

(11) **EP 2 582 549 B1**
(45) Veröffentlichungstag und Bekanntmachung des Hinweises auf die Patenterteilung: **15.10.2014**
(21) Anmeldenummer: 11726106.5
(22) Anmeldetag: 09.06.2011
(51) Int. Cl.: B60R 16/023, H01R 13/52

(54) **ELEKTRISCHE VORRICHTUNG**
ELECTRICAL DEVICE
DISPOSITIF ÉLECTRIQUE

(30) Priorität: 10.08.2010 DE 102010033908; 16.06.2010 DE 102010023909
(43) Veröffentlichungstag der Anmeldung: 24.04.2013
(73) Patentinhaber: Continental Automotive GmbH, 30165 Hannover (DE)
(72) Erfinder: SCHMID, Thomas, 93051 Regensburg (DE); HERDEG, Björn, 93047 Regensburg (DE); SMIT, Arnoud, 93053 Regensburg (DE); RIEPL, Toni, 93342 Saal A. D. Donau (DE); ZELLER, Robert, 93142 Maxhütte-Haidhof (DE); GSCHOSSMANN, Hans, 93092 Barbing (DE); FENCHEL, Frank, 35510 Butzbach (DE)
(86) Internationale Anmeldenummer: PCT/EP2011/059605
(87) Internationale Veröffentlichungsnummer: WO 2011/157626

(56) Entgegenhaltungen:
- EP-A1- 0 641 154
- DE-A1- 4 135 679
- DE-A1-102004 007 180
- FR-A1- 2 878 656
- US-A1- 2006 063 412

## Beschreibung

Die vorliegende Erfindung betrifft eine elektrische Vorrichtung mit einer elektrischen bzw. elektronischen Komponente und einem diese Komponente umschließenden Gehäuse, wobei diese Vorrichtung eine luftdicht ausgeführte stabile elektrische Verbindung vom Gehäuseinneren in das Gehäuseäußere aufweist.

Gattungsgemäße Vorrichtungen, siehe z.B. FR 2 878 656, werden nahezu in allen technischen Bereichen, insb. als Steuergeräte oder Energiespeicher eines Fahrzeugs, verwendet und weisen eine elektrische Verbindung auf, welche elektrische Signale oder elektrischen Strom vom Gehäuseinneren in das Gehäuseäußere oder umgekehrt leitet.

Elektrische bzw. elektronische Komponenten werden in der Regel in einem Gehäuse angeordnet, um diese von den Umfeldeinflüssen wie Staub, Feuchtigkeit etc. zu schützen. Um diese Komponenten vor äußeren Umfeldeinflüssen zu schützen, müssen die Gehäuse luftdicht verschlossen sein. Zudem sollen die Gehäuse die Komponenten vor Stößen schützen.

Dabei ist jedoch erforderlich, elektrische Verbindung von den im Innen des Gehäuses befindenden Komponenten zum außerhalb vom Gehäuse befindlichen Strom- oder Signalkabel herzustellen. Diese elektrische Verbindung wird in der Regel mithilfe eines am Kabelende angeordneten Kabelschuhs hergestellt, der mit einem elektrisch leitfähigen Stromleiter über einen Bolzen fest verbunden und elektrisch kurzgeschlossen ist.

Das Problem bei Herstellung einer elektrischen Verbindung zwischen einem außerhalb vom Gehäuse befindlichen stromführenden Kabel und einer elektrischen Komponente im Gehäuseinneren einer Steuergeräte oder eines Energiespeichervorrichtung eines Fahrzeugs mittels eines Kabelschuhs sind die sehr unterschiedlichen und gegensätzlichen Anforderungen,an dem Kabelschuh.

Der Kabelschuh muss mit einem großen Moment am Gehäuse der elektrischen Vorrichtung angeschraubt werden, um Bewegungen gegenüber den elektrischen Komponenten während des Betriebs der Vorrichtung zu verhindern und eine dauerhafte stabile elektrische Verbindung zwischen dem Kabel und den elektrischen Komponenten sicherzustellen.

Dabei darf die elektrische Verbindung während des Betriebs des Fahrzeugs nicht bewegen, weil sie mit der elektrischen bzw. elektronischen Komponente, wie z. B. Leiterplatte oder Batteriezelle, im Innen des Gehäuses hartgelötet wird, und diese Komponente wiederum keine Krafteinwirkung verträgt.

Zudem erwies sich die Stelle, wo die elektrische Verbindung vom Gehäuseinneren in das Gehäuseäußere ausgeführt ist, als Schwachstelle zur Abdichtung des Gehäuses der Vorrichtung.

Die derzeit weit verbreitete Methode zur Abdichtung der elektrischen Verbindungsstelle mit um den als elektrische Verbindung dienenden Stromleiter umspritztem Kunststoff gewährleistet keine dauerhafte Abdichtung des Gehäuses. Durch die nicht vermeidbaren Temperaturschwankungen in der Umgebung der Vorrichtung löst sich der um den Stromleiter herum angebrachte Kunststoffspritzguss vom Stromleiter und verliert dadurch seine Abdichtungswirkung.

Die Aufgabe der vorliegenden Erfindung liegt somit darin, eine elektrische Vorrichtung der eingangs genannten Art so zu modifizieren, dass dieses eine elektrische Verbindung aufweist, welche bei starken Temperaturschwankungen dauerhaft luftdicht verschlossen bleibt.

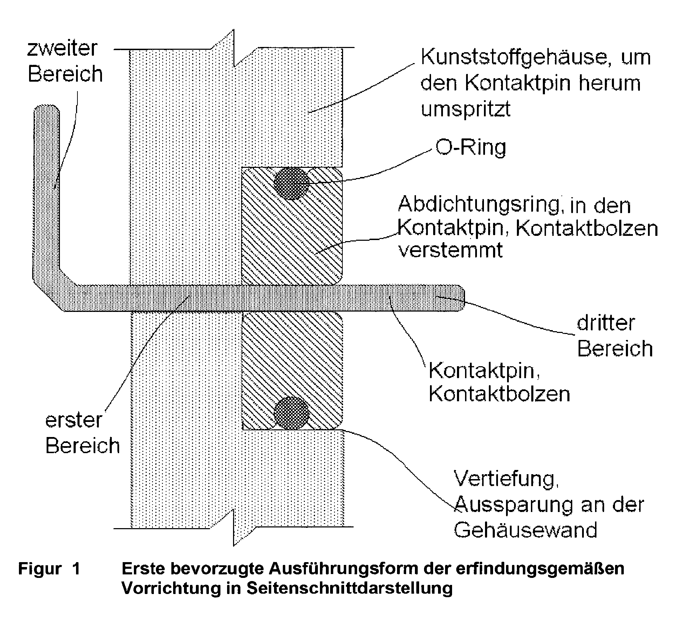

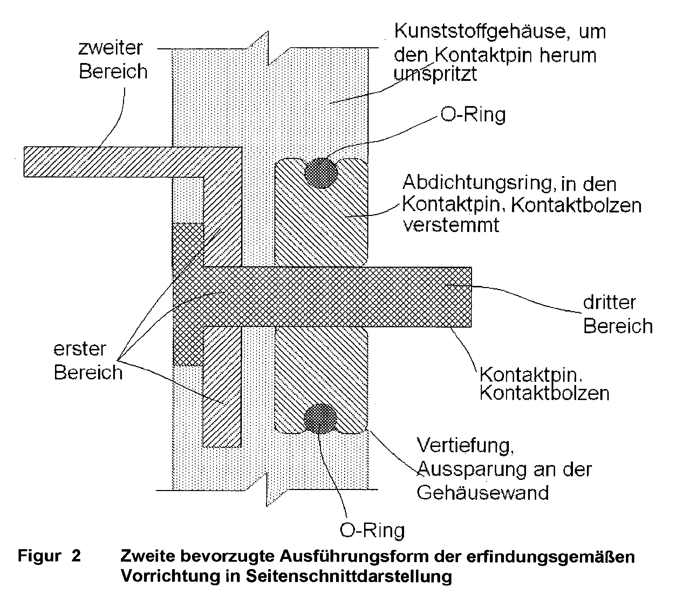

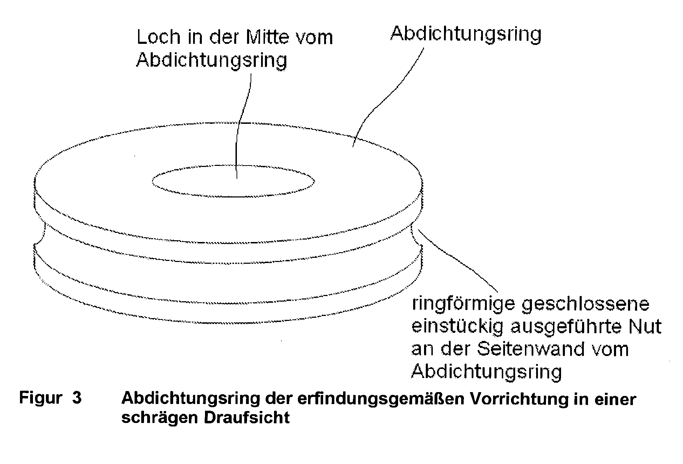

Diese Aufgabe ist mit einer elektrischen Vorrichtung mit einem elektrischen Kontaktelement und einem Gehäuse mit einer Gehäusewand, wobei das Kontaktelement von der Gehäusewand umspritzt ist, mit den Merkmalen des Anspruchs 1 gelöst. Zwei bevorzugten Ausführungsformen der erfindungsgemäßen Vorrichtung stellen die Figuren 1 bis 3 dar. Demnach weist die Gehäusewand der Vorrichtung um das Kontaktelement herum eine Vertiefung (bzw. Aussparung, welche vorzugsweise die Gehäusewand nicht durchlocht) auf, wobei in dieser Vertiefung ein Abdichtungsmittel angeordnet ist.

Das Abdichtungsmittel ist ein Abdichtungsring, wobei das Kontaktelement in das Abdichtungsmittel luftdicht verstemmt ist. Alternativ ist das Kontaktelement mit dem Abdichtungsmittel luftdicht gelötet bzw. geschweißt.

Der Abdichtungsring, welcher vorzugsweise aus elastoplastisch verformbarem Material wie Metall besteht, weist an der Seitenwand eine ringförmige geschlossene einstückig ausgeführte Nut auf, wobei in dieser Nut ein O-Ring überzogen ist. Dieser O-Ring dichtet den Zwischenraum zwischen der Vertiefung und dem Abdichtungsring von der Umgebung luftdicht ab.

Vorzugsweise, insb. im Falle der Verstemmung des Kontaktelements in das Abdichtungsmittel ist das Kontaktelement so ausgeformt, dass dieses einen kreisförmigen Querschnitt aufweist. Ein kreisförmiger Querschnitt des Kontaktelements wirkt positiv auf die Dichtigkeit der Verstemmung.

Vorzugsweise ist das Kontaktelement ein Kontaktpin für eine Steckerverbindung oder ein Kontaktbolzen mit einem angeformten Gewinde, in den ein Kabelschuh verschraubt werden kann.

Das Kontaktelement umfasst vorzugsweise einen von der Gehäusewand umspritzt in der Gehäusewand befindlichen ersten Bereich, einen innerhalb vom Gehäuse befindlichen zweiten Bereich sowie einen außerhalb vom Gehäuse befindlichen dritten Bereich, wobei die ersten und zweiten Bereiche zueinander abgewinkelt sind.

Das Kontaktelement umfasst ferner einen Kontaktbolzen und einen Kontaktstanzteil, wobei der Kontaktstanzteil einen von der Gehäusewand umspritzt in der Gehäusewand befindlichen ersten Bereich und einen innerhalb vom Gehäuse befindlichen zweiten Bereich aufweist, wobei die ersten und zweiten Bereiche zueinander abgewinkelt sind. Dabei der Kontaktbolzen ist in den ersten Bereich des Kontaktstanzteils verstemmt.

Dabei ist der Kontaktbolzen in den Kontaktstanzteil eingepresst, wobei sich der Kontaktbolzen und der Kontaktstanzteil in jeweiligen Bereichen, wo sich die beiden Teile zueinander berühren, verformen und so eine formschlüssige und luftdichte stabile Verbindung zwischen diesen beiden Teilen entsteht. Danach ist der Kontaktbolzen samt dem Kontaktstanzteil von dem Kunststoffgehäuse umspritzt, wobei eine Runde Kavität also Vertiefung an der Wand des Kunststoffgehäuses rund um den Kontaktbolzen zum Anordnen des Abdichtungsrings übrig gelassen wird.

So ist eine elektrische Verbindung vom Gehäuseinneren ins Gehäuseäußeren geschaffen, welche luftdicht abdichtet ist und so das Gehäuseinneren vor Eindringen von Feuchtigkeit oder Staub schützt und zudem verhindert, dass der aluminiumhaltige Stromleiterelemente im Innern des Gehäuses mit der Luft vom Gehäuseaußen in Berührung kommt und oxidiert.

Durch die Anwendung eines niederohmigen Kontaktelements bzw. Kontaktpins oder Kontaktbolzens, welches mit dem Kontaktstanzteil durch Verstemmung großflächig elektrisch kontaktiert ist, ist eine niederohmige elektrische Verbindung geschaffen, welcher zugleich stabil und luftdicht abgedichtet ist.

Der Abdichtungsring verformt sich durch das Verstemmen um den Kontaktpin bzw. -bolzen rum. Dadurch kriegt der Kontaktpin bzw. -bolzen mehr halt und wird der Widerstand gegen Verdrehen erhöht.

Es ist eine elektrische Verbindung für eine in einem geschlossenen Gehäuse angeordnete elektrische bzw. elektronische Komponente wie z. B. Batteriezelle, Leiterplatte geschaffen, welche die Anforderungen auf hohe Dichtung, niedrigen Stromübergangswiderstand, hohe Drehmomentfestigkeit, guten Korrosionsschutz bei den Komponenten der elektrischen Verbindung erfüllt.

## Patentansprüche

1. Elektrische Vorrichtung mit einem elektrischen Kontaktelement und einem Gehäuse mit einer Gehäusewand, wobei das Kontaktelement von der Gehäusewand umspritzt ist, wobei die Gehäusewand um das Kontaktelement herum eine Vertiefung aufweist, wobei in dieser Vertiefung ein Abdichtungsmittel angeordnet ist,
wobei das Abdichtungsmittel ein Abdichtungsring ist, **dadurch gekennezeichnet, dass** der Abdichtungsring an der Seitenwand eine ringförmige geschlossene einstückig ausgeführte Nut aufweist, wobei in dieser Nut ein O-Ring überzogen ist.

2. Elektrische Vorrichtung nach Anspruch 1, wobei das Kontaktelement in das Abdichtungsmittel luftdicht verstemmt ist.

3. Elektrische Vorrichtung nach Anspruch 1, wobei das Kontaktelement mit dem Abdichtungsmittel luftdicht gelötet bzw. geschweißt ist.

4. Elektrische Vorrichtung nach einem der vorangehenden Ansprüche, wobei das Kontaktelement einen von der Gehäusewand umspritzt in der Gehäusewand befindlichen ersten Bereich, einen innerhalb vom Gehäuse befindlichen zweiten Bereich sowie einen außerhalb vom Gehäuse befindlichen dritten Bereich aufweist, wobei die ersten und zweiten Bereiche zueinander abgewinkelt sind.

5. Elektrische Vorrichtung nach einem der vorangehenden Ansprüche, wobei das Kontaktelement einen Kontaktbolzen und einen Kontaktstanzteil umfasst, wobei der Kontaktstanzteil einen von der Gehäusewand umspritzt in der Gehäusewand befindlichen ersten Bereich und einen innerhalb vom Gehäuse befindlichen zweiten Bereich aufweist, wobei die ersten und zweiten Bereiche zueinander abgewinkelt sind.

6. Elektrische Vorrichtung nach Anspruch 5, wobei der Kontaktbolzen in den ersten Bereich des Kontaktstanzteils verstemmt ist.

## Claims

1. Electrical device comprising an electrical contact element and a housing having a housing wall, wherein the contact element is encapsulated by injection moulding by the housing wall, wherein the housing wall has a depression around the contact element, wherein a sealing means is arranged in this depression, wherein the sealing means is a sealing ring, **characterized in that** the sealing ring has, on the side wall, a ring-shaped, closed, integral groove, wherein an 0 ring is overlaid in this groove.

2. Electrical device according to Claim 1, wherein the contact element is caulked in air-tight fashion into the sealing means.

3. Electrical device according to Claim 1, wherein the contact element is soldered or welded to the sealing means in air-tight fashion.

4. Electrical device according to one of the preceding claims, wherein the contact element has a first region which is located in the housing wall, encapsulated by injection moulding by the housing wall, a second region located within the housing and a third region located outside the housing, wherein the first and second regions are at an angle with respect to one another.

5. Electrical device according to one of the preceding claims, wherein the contact element comprises a contact stud and a contact stamped part, wherein the contact stamped part has a first region which is located in the housing wall, encapsulated by injection moulding by the housing wall, and a second region located within the housing, wherein the first and second regions are at an angle with respect to one another.

6. Electrical device according to Claim 5, wherein the contact stud is caulked into the first region of the contact stamped part.

## Revendications

1. Dispositif électrique comportant un élément de contact électrique et un boîtier avec une paroi de boîtier, l'élément de contact étant moulé dans la paroi de boîtier, la paroi de boîtier comprenant, autour de l'élément de contact, un évidement, un moyen d'étanchéité se trouvant dans cet évidement, le moyen d'étanchéité étant une bague d'étanchéité, **caractérisé en ce que** la bague d'étanchéité comprend, sur la paroi latérale, une rainure annulaire et fermée, réalisée d'une seule pièce, un joint torique se trouvant dans cette rainure.

2. Dispositif électrique selon la revendication 1, l'élément de contact étant maté de manière étanche à l'air dans le moyen d'étanchéité.

3. Dispositif électrique selon la revendication 1, l'élément de contact étant brasé ou soudé de manière étanche à l'air avec le moyen d'étanchéité.

4. Dispositif électrique selon l'une des revendications précédentes, l'élément de contact comprenant une première partie se trouvant dans la paroi de boîtier et moulée dans la paroi de boîtier, une deuxième partie se trouvant à l'intérieur du boîtier ainsi qu'une troisième partie se trouvant hors du boîtier, les première et deuxième parties formant un angle entre elles.

5. Dispositif électrique selon l'une des revendications précédentes, l'élément de contact comprenant une broche de contact et un poinçon de contact, le poinçon de contact comprenant une première partie se trouvant dans la paroi de boîtier et moulée dans la paroi de boîtier, une deuxième partie se trouvant à l'intérieur du boîtier, le première et deuxième parties formant un angle entre elles.

6. Dispositif électrique selon la revendication 5, la broche de contact étant matée dans la première partie du poinçon de contact.
